Europäisches Patentamt

European Patent Office

Office européen des brevets

(11) Veröffentlichungsnummer: **0 043 789**
**A2**

## (12) EUROPÄISCHE PATENTANMELDUNG

(21) Anmeldenummer: 81730063.5

(22) Anmeldetag: 03.07.81

(51) Int. Cl.³: **H 05 B 7/16**

(30) Priorität: 08.07.80 DE 3026164

(43) Veröffentlichungstag der Anmeldung: 13.01.82
Patentblatt 82/2

(84) Benannte Vertragsstaaten: **CH FR GB IT LI NL SE**

(71) Anmelder: **Europäische Atomgemeinschaft (EURATOM), Europazentrum Kirchberg, Luxemburg (LU)**

(72) Erfinder: **Brandt, Berthold, Dr., FOM-Instituut voor Plasmafysica, Nieuwegein (NL)**
Erfinder: **Dietz, Jürgen, Dr., Jet, Culham (GB)**
Erfinder: **Waelbroeck, François, Prof.Dr., KFA, Jülich (DE)**
Erfinder: **Winter, Jörg, Dr., KFA, Jülich (DE)**

(74) Vertreter: **Müller-Börner, Richard, Dipl.-Ing., Patentanwälte Müller-Börner, Wey & Körner Podbielskiallee 68, D-1000 Berlin-Dahlem 33 (DE)**

(54) Verfahren und Vorrichtung zur entladungschemischen Behandlung empfindlicher Werkstücke durch Einsatz der Glimmentladung.

(57) Verfahren zur entladungschemischen Behandlung empfindlicher Werkstücke durch Einsatz einer Glimmentladung in einem Arbeitsgefäß, in dem das Werkstück nicht zur Elektrode gemacht wird, sondern die Entladungsstrecke als selbständige operative Einheit ausgebildet und betrieben wird, während das Werkstück geometrisch in entladungschemisch günstiger Weise im Wirkungsbereich der Entladungsstrecke plaziert ist.

- 1 -

Verfahren und Vorrichtung zur entladungschemischen
Behandlung empfindlicher Werkstücke durch Einsatz
der Glimmentladung

Es ist bekannt, mit Hilfe von Glimmentladungen die
Arbeitsqualität von Werkstücken zu verbessern (vgl.
deutsche Patentanmeldung P 26 47 088.2-15 vom
19.10.76). Beispielsweise läßt man unter Einwirkung
der Glimmentladung Wasserstoff, Sauerstoff, Stickstoff oder Kohlenstoff mit der Werkstückoberfläche
reagieren.

Dabei ist es üblich, das Werkstück elektrisch als
Elektrode der Glimmentladungsstrecke, vorzugsweise
als Kathode, zu schalten. Auf diese Weise erreicht
man, daß die entstehenden Ionen als aktive Spezies
unmittelbar durch den Kathodenfall auf die Kathode,
d.h. das Werkstück, gebracht werden und daß dabei
zugleich die Entladungsenergie zur Heizung des
Werkstücks genutzt wird.

Allerdings kann es bei dieser Betriebsweise zu einem
Umschlag der Glimmentladung in einen Lichtbogen
kommen, besonders im Falle grösserer Werkstücke und
bei Stromstärken über 1 Ampère. Dadurch werden die

- 2 -

Elektroden resp. das Werkstück unter Umständen stark beschädigt. Es sind daher schon Maßnahmen vorgeschlagen worden, den Umschlag der Entladungsform zu unterdrücken oder den eingetretenen Lichtbogen sofort abzuschalten (vgl. W. Weizel, B. Brandt Forsch.Ber.Nordrhein-Westfalen Nr.551 (1958)).

Gegenstand der Erfindung ist ein Verfahren und eine Vorrichtung zur entladungschemischen Behandlung von Werkstücken durch Einsatz der Glimmentladung in einem Arbeitsgefäß, bei der die Bildung eines Lichtbogens auf dem Werkstück ohne besondere Hilfsmittel vermieden wird und die entladungschemische Wirksamkeit der Glimmentladung vorteilhaft zur Entfaltung gebracht wird. Das wird dadurch erreicht, daß erfindungsgemäß die Entladungsstrecke als selbständige operative Einheit ausgebildet und betrieben wird, während das Werkstück selbst elektrisch nicht in die Entladungsstrecke aufgenommen, aber geometrisch in entladungschemisch günstiger Weise im Wirkungsbereich der Entladungsstrecke plaziert ist.

Das Werkstück wird also nicht zur Elektrode gemacht, d.h. es wird bewußt auf die Ausnutzung des Kathodenfalls der klassischen Glimmentladung und ggf. der direkten Heizung des Werkstückes durch den Entladungsstrom verzichtet. Vielmehr wird dem Prozess gewissermassen eine zusätzliche Elektrode (hier Kathode) zur Verfügung gestellt, d.h. die Glimmentladung kann werkstückunabhängig und so betrieben werden, daß als aktive Spezies aus der Entladung neben den Ionen vor allem Atome des im Prozess mitwirkenden Arbeitsgases gebildet werden, welches üblicherweise in molekularer Form vorliegt. Die so gebildeten Spezies gelangen durch Diffusion und ggf. unterstützte Gasströmung auf das Werkstück.

Zum Verständnis der Erfindung kann man in Gedanken das Glimmentladungsplasma verlassen und sich dem Bogenplasma zuwenden. Chemisch ist relevant, daß das Bogenplasma sich angenähert im thermischen Gleichgewicht befindet, während es im relativ kalten Arbeitsgas der Glimmentladung sehr viele Spezies gibt, die im Gleichgewicht nur bei sehr hohen Temperaturen vorkämen. Für die Anwendung des Lichtbogenplasmas brachte die Einführung des Plasmabrenners mit seinem vom Werkstück unabhängigen System von Elektroden und Stromversorgung neben der ursprünglichen direkten Anwendung des Lichtbogens auf das als Elektrode geschaltete Werkstück eine Verbreiterung der Betriebsmöglichkeiten.

Analog kann man mit der vorliegenden Erfindung eine Verbreiterung der Glimmentladungsanwendung erzielen. Als ein besonderer Vorzug ergibt sich zusätzlich der Schutz des Werkstücks bei einem Umschlag der Entladung in den heißen Bogen, der in seinem Brennfleck höchstens die Elektrode schädigen würde.

- 4 -

Handelt es sich bei der Entladungsbehandlung z.B.
um die Ausgasung eines Gefässes, dessen Innenwandung von Sauerstoff besetzt ist, würde bei Verwendung von Wasserstoff als Arbeitsgas die entladungschemische Behandlung in der Erleichterung
der chemischen Bindung dieser beiden Gase unter
Bildung von Wasserdampf bestehen, der abgepumpt
wird.

Soweit erforderlich, kann die Beheizung des Werkstücks auf jede gewünschte Behandlungstemperatur
in beliebiger Weise bewirkt werden (z.B.elektrische
Beheizung, Flammheizung); eine Abhängigkeit vom
Entladungsstrom der Glimmstrecke besteht jedenfalls
nicht mehr, so daß die Entladung in den meisten
Fällen mit sehr kleiner Stromdichte, in der Größenordnung 0,1 A/m$^2$, betrieben werden kann. Es bleibt
durch geeignete bauliche und gestalterische Maßnahmen möglich, auch die in der Glimmentladungsstrecke anfallende Entladungsenergie zur Beheizung
des Werkstücks nutzbar zu machen. Die Maßnahmen
können sich auf die Erfassung der Strahlungswärme,
den Wärmetransport durch Leitung oder die Lenkung
der Strömungswärme beziehen.

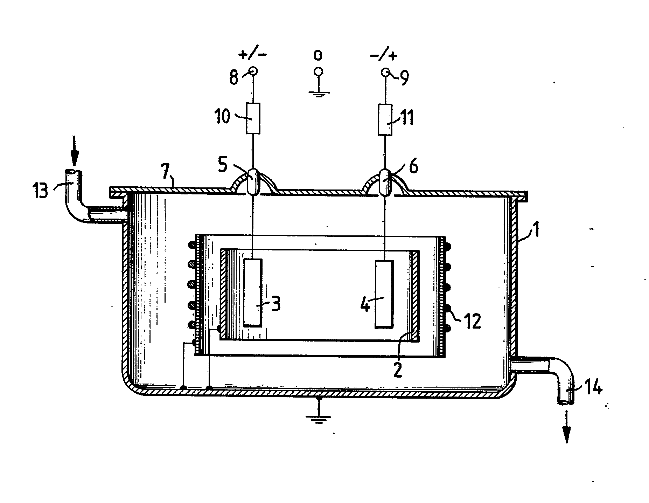

In der Zeichnung ist schematisch ein Ausführungsbeispiel der Vorrichtung zur Durchführung des neuen
Verfahrens dargestellt.

Es bedeuten: 1) das Vakuum-Arbeitsgefäß zur Aufnahme
der Prozesselemente und

- 5 -

2) das Werkstück, hier ein Zylinderring aus Stahl.

Erfindungsgemäß ist die Glimmentladungsstrecke, bestehend aus den Elektroden 3,4 als selbständige
operative Einheit ausgebildet. Die Elektroden sind
durch die isolierenden Vakuumdurchführungen 5,6 im
Deckel 7 des Vakuumgefässes nach außen zu den
elektrischen Anschlußpolen 8, 9 geführt, unter Einschaltung der Stromstabilisatoren 10, 11.

Um das Werkstück und die Elektroden ist eine elektrische Heizung 12 angeordnet. Der Wicklungsträger
ist, ebenso wie das Werkstück, an Erde gelegt. Über
die Ein- und Austrittsleitungen 13, 14 wird das Vakuumgefäß durch eine Pumpe mit dem Arbeitsgas beaufschlagt.

Als Spannungsquelle kann eine Gleich- oder Wechselstromquelle, letzteren Falls auch eine Drehstromquelle
(z.B. 3 Elektroden in Sternschaltung) verwendet werden.
Den Elektroden wird vorzugsweise eine Spannung symmetrisch zum Werkstück zugeführt, das hier als geerdet
gezeichnet ist.

Die Erfindung kann in der Weise ausgebaut werden, daß
der Schutz gegen Lichtbogenbildung weiter verstärkt
wird. Hierzu wird der Zahlenwert des normalen Kathodenfalls ins Spiel gebracht: durch entsprechende Materialwahl der Elektroden kann erreicht werden, daß der zu
dem Paar "Entladungsgas - Werkstückmaterial" gehörende
normale Kathodenfall größer als derjenige für das Paar
"Entladungsgas - Elektrodenmaterial" ausfällt: Auf diese

- 6 -

Weise kann mit höherer Sicherheit gegen Bogenbildung gearbeitet werden, denn die Entladungsspannung kann dann kleiner sein als für einen
Glimmentladungsansatz auf dem Werkstück nötig
wäre, bzw. sie kann kleiner als der doppelte Wert
der eben genannten Spannung sein, wenn gleichzeitig in Bezug auf das Werkstück die Symmetrie des
elektrischen Potentials an den Elektroden gewährleistet ist. In keinem dieser Fälle könnte es zu
einem Glimmentladungsansatz auf dem Werkstück kommen
und also erst recht nicht zu einem Bogenansatz, der
über eine Glimmentladung erfolgen würde.

Ferner können Grösse, Form und Anzahl der Elektroden
auf die vorhandenen Stromquellen, auf die Grösse
und Form des Werkstücks und auf das besondere Behandlungsziel abgestimmt werden. Dabei handelt es
sich in erster Linie um die Entfernung von Verunreinigungen vom Werkstück. Die Erfindung kann
aber auch für die Bildung von Niederschlägen auf
Werkstücken oder für eine chemische Veränderung
der Oberfläche wie beim Nitrierhärten eingesetzt
werden.

Das vorstehend beschriebene Verfahren und seine
Anordnungsweise ist besonders für die Säuberung
von Vakuumgefässen sowie für die Ausgasung solcher
Gefässe geeignet. In diesem Falle bildet das Gefäss
selber das Werkstück im Sinne der Erfindung. Eine
für die Erfindung besonders interessante Anwendung
stellt die Reinigung und Ausgasung des Reaktionsgefässes (Plasmakanal) von Kernfusionsanlagen dar.

Die inneren Oberflächen dieser Gefässe sind betriebstechnisch besonders delikat, und es wäre nicht zu
vertreten, wenn sie bei Anwendung der bisher bekannten Glimmentladungstechnik durch Lichtbogenbildung beschädigt würden. Mit den hier beschriebenen
Mitteln ist diese Gefahr ausgeschlossen.

- 8 -

## Patentansprüche

1. Verfahren zur entladungschemischen Behandlung empfindlicher Werkstücke durch Einsatz einer Glimmentladung in einem Arbeitsgefäß, d a d u r c h g e k e n n z e i c h n e t, daß die Entladungsstrecke als selbständige operative Einheit ausgebildet und betrieben wird, während das Werkstück elektrisch nicht in die Entladungsstrecke aufgenommen, aber geometrisch in entladungschemisch günstiger Weise im Wirkungsbereich der Entladungsstrecke plaziert ist.

2. Verfahren nach Anspruch 1, d a d u r c h g e k e n n z e i c h n e t, daß für die Kathode bzw. für die Elektroden der selbständigen Entladungsstrecke Material gebraucht wird, für das bei dem gegebenen Entladungsgas der Wert des normalen Kathodenfalls kleiner ist als der für das Material des Werkstücks.

3. Verfahren nach Anspruch 1, d a d u r c h g e k e n n z e i c h n e t, daß das Werkstück auf einem elektrischen Potential gehalten wird, welches in der Mitte zwischen den Potentialen der Entladungselektroden liegt.

4. Verfahren nach Anspruch 1, d a d u r c h g e k e n n z e i c h n e t, daß bei hohlen Werkstücken das Werkstück direkt als Arbeitsgefäß dient.

- 9 -

5. Vorrichtung zur Durchführung des Verfahrens,
g e k e n n z e i c h n e t   d u r c h  Mittel
und Massnahmen zur Beheizung des Werkstücks,zur
Nutzung des Kathodenfalls der beteiligten Prozesskomponenten und zur gestaltungstechnischen Anpassung
an die Geometrie des Werkstücks sowie die elektrische Betriebsweise der Entladungsstrecke.